# EUROPÄISCHE PATENTSCHRIFT

(11) **EP 2 697 834 B1**
(45) Veröffentlichungstag und Bekanntmachung des Hinweises auf die Patenterteilung: **06.04.2016**
(21) Anmeldenummer: 12717638.6
(22) Anmeldetag: 13.04.2012
(51) Int. Cl.: H01L 31/02, H01L 31/042, H01L 31/048, H01L 31/05, H02S 30/10, H01M 10/46, B60L 8/00, B60J 7/00

(54) **BAUELEMENT MIT SOLARZELLEN FÜR FAHRZEUGDÄCHER UND GEBÄUDE**
COMPONENT WITH SOLAR CELLS FOR VEHICLE ROOFS AND BUILDINGS
ÉLÉMENT STRUCTURAL PRÉSENTANT DES CELLULES SOLAIRES POUR TOITS DE VÉHICULES ET BÂTIMENTS

(30) Priorität: 14.04.2011 DE 102011007355
(43) Veröffentlichungstag der Anmeldung: 19.02.2014
(73) Patentinhaber: A2 - Solar Advanced and Automotive Solar Systems GmbH, 99099 Erfurt (DE)
(72) Erfinder: WECKER, Reinhard, 99425 Weimar (DE)
(74) Vertreter: Lohr, Georg
(86) Internationale Anmeldenummer: PCT/EP2012/056841
(87) Internationale Veröffentlichungsnummer: WO 2012/140236

(56) Entgegenhaltungen:
- EP-A2- 1 245 418
- DE-A1- 4 105 396

## Beschreibung

### Technisches Gebiet

Die Erfindung betrifft ein Bauelement mit Solarzellen, welches als Glasdeckel für Fahrzeugdächer oder auch als Fassadenelement für Gebäude einsetzbar ist.

### Stand der Technik

Sowohl beim Einsatz an Gebäuden als auch in Kraftfahrzeugen werden hohe Anforderungen an die mechanische Festigkeit und Stabilität solcher Bauelemente gestellt. So müssen diese Bauelemente beim Einsatz in Fassaden insbesondere durch Windbelastungen hohen Zug- und Druckkräften standhalten. Zudem dürfen auch bei einer Beschädigung des Bauelements nicht einzelne Bestandteile von der Fassade herabfallen. Beim Einsatz als Glasdeckel in Kraftfahrzeugen muss ein solches Bauelement ebenfalls hohen Zug- und Druckkräften widerstehen. Zudem können gerade bei Unfällen kurzfristige, extrem starke Belastungen auftreten. Auch in solchen Situationen dürfen sich nicht einzelne Bestandteile von dem Bauelement lösen. Insbesondere soll das ganze Bauelement fest am Fahrzeug gehalten werden.

In der DE 10 2004 059959 A1 ist ein Bauelement zur Verglasung eines Bauwerks offenbart. Es weist eine Glasplatte auf, an deren Unterseite Solarzellen angebracht sind. Weiterhin ist auf der Rückseite der Solarzellen eine Splitterschutzfolie vorgesehen. Eine solche Splitterschutzfolie ist üblicherweise fest durch Laminieren mit den Solarzellen und mit der Glasplatte verbunden. Sie kann somit das Herausfallen von einzelnen Splittern aus der Glasplatte verhindern. Weiterhin offenbart dieses Dokument eine mechanische Befestigung der Splitterschutzfolie, um die mechanische Stabilität weiter zu erhöhen. Nachteilig an dieser Anordnung ist der höhere mechanische Aufwand durch die separate Befestigung der Splitterschutzfolie, sowie eine begrenzte Wirksamkeit der Maßnahme durch die begrenzte Reißfestigkeit der Splitterschutzfolie.

In der EP 1006 593 B1 ist ein Solarmodul mit einem integrierten Steckverbinder offenbart. Dieser ermöglicht eine besonders einfache elektrische Verbindung mit dem Solarmodul.

In der EP 1 245 418 wird ein als Solargenerator ausgebildeter Deckel zum Verschließen einer Öffnung in der Karosserie eines Fahrzeugs offenbart. Dieser Deckel weist eine transparente Scheibe mit darunter liegenden Solarzellen auf, wobei die Scheibe an einen Rahmen auf Polyurethan-Basis angespritzt bzw. angeschäumt ist.

### Darstellung der Erfindung

Der Erfindung liegt die Aufgabe zugrunde, ein Bauelement mit Solarzellen zur Verglasung eines Bauwerks und/oder zum Einsatz als Deckel für ein Kraftfahrzeug sowie ein Verfahren zur Herstellung eines solchen Bauelements derart auszugestalten, dass dieses eine erhöhte mechanische Stabilität und Festigkeit aufweist. Zudem soll es mit relativ geringem Aufwand zu geringen Kosten herstellbar sein.

Diese Aufgabe wird durch eine Vorrichtung nach Anspruch 1 gelöst. Vorteilhafte Ausgestaltungen der Erfindung sind in den Unteransprüchen angegeben.

Ein erfindungsgemäßes Bauelement umfasst eine Glasscheibe mit wenigstens einer Solarzelle, wobei die Glasscheibe in zumindest einem Bereich ein Schaumelement aufweist. Weiterhin ist wenigstens ein Zellverbinder zur elektrischen Verbindung der wenigstens einen Solarzelle vorgesehen, welcher in das Schaumelement hineinragt und bevorzugt Mittel zur Vergrößerung der Haftung in dem Schaumelement aufweist.

Die Glasscheibe besteht bevorzugt aus Einscheiben-Sicherheitsglas (ESG), welches bevorzugt durch eine spezielle Wärmebehandlung eine erhöhte Stoß- und Schlagfestigkeit aufweist. Die Glasscheibe kann von ihrer Größe und Form an das jeweilige Einsatzgebiet, wie beispielsweise für eine Gebäudefassade oder für ein Kraftfahrzeug, ausgelegt sein. Sie kann auch eine Einfärbung öder eine Bedruckung aufweisen. Die Glasscheibe weist zumindest in einem Randbereich ein Schaumelement auf. Bevorzugt ist das Schaumelement eine Umschäumung, die den gesamten Randbereich umfasst. Das Schaumelement kann aber auch nur ein kurzes Stück Schaum sein. Das Schaumelement umfasst bevorzugt einen Dauerelastischen Schaum. Ein solcher Schaum kann beispielsweise ein Polyurethan umfassen. Durch das Schaumelement kann eine Verbindung mit einem Rahmen oder einer äußeren tragenden Struktur zur Aufnahme der Scheibe hergestellt werden. Das Schaumelement erlaubt eine gewisse mechanische Ausdehnung der Glasscheibe gegenüber der tragenden Struktur und absorbiert Schwingungen und Stöße. Zudem ermöglicht er eine Abdichtung, so dass insbesondere von außen kein Wasser eindringen kann. Auf der Glasscheibe befindet sich wenigstens eine Solarzelle. Diese Solarzelle ist bevorzugt auf der Unterseite bzw. Innenseite angeordnet, so dass sie durch die Glasscheibe von Umwelteinflüssen geschützt ist. Bevorzugt ist eine größere Anzahl von Solarzellen, besonders bevorzugt in einer matrixförmigen Anordnung vorgesehen, um eine wirtschaftliche Herstellung zu ermöglichen. Um eine höhere und damit leichter zu verarbeitende Ausgangsspannung zu erreichen, werden die Solarzellen bevorzugt hintereinander (in Serie) geschaltet. Grundsätzlich ist aber auch eine Parallelschaltung oder eine kombinierte Serien-/Parallelschaltung möglich. Zur Verbindung der Solarzellen untereinander sind Zellverbinder vorgesehen. Durch derartige Zellverbinder werden bevorzugt benachbarte Solarzellen miteinander verbunden. Zudem dienen diese Zellverbinder auch zum äußeren Anschluss der Solarzellen, um sie beispielsweise mit einer Last oder einem Verbraucher zu verbinden. Die wenigstens eine Solarzelle ist bevorzugt fest mit der Glasscheibe verbunden. Eine solche Verbindung kann durch Aufkleben, Laminieren oder ein anderes, dem Stand der Technik entsprechendes Befestigungsverfahren erfolgen. Besonders bevorzugt wird die wenigstens eine Solarzelle mit Hilfe wenigstens einer Folie auf die Glasscheibe laminiert. Es kann hierbei wenigstens eine Folie zwischen der wenigstens einen Solarzelle und der Glasscheibe vorgesehen sein. Besonders bevorzugt ist es, wenn wenigstens eine Folie auf der der Glasscheibe abgewandten Seite der wenigstens einen Solarzelle vorgesehen ist, so dass die wenigstens eine Solarzelle zwischen der Folie und der Glasscheibe eingeschlossen ist. Besonders bevorzugt ist es, wenn eine solche Folie eine Ethyl-Vinyl-Acetat-Folie (EVA) oder eine Polyvinyl-Butyral-Folie (PVB) ist. Derartige Folien zeichnen sich durch hohe mechanische Stabilität und hohe Reißfestigkeit aus. Durch den Einsatz einer solchen Folie kann eine hohe Splitterfestigkeit des Bauelements erreicht werden.

Um im Falle der Beschädigung eines Bauelements, wie es beispielsweise in einer Fassade eingebaut ist, oder auch im Falle eines Unfalls eine Glasdeckels eines Kraftfahrzeugs, ein Herausbrechen von Teilen aus dem Bauelement oder des ganzen Bauelements selbst aus einer Halterung zu vermeiden, wird eine stabile Verankerung des Bauelements erreicht, indem wenigstens ein Zellverbinder der Solarzellen in das äußere Schaumelement mit eingeschäumt werden und die Zellverbinder bevorzugt zusätzliche Mittel zur Erhöhung der mechanischen Stabilität und der Auszugskraft aus dem Schaumelement aufweisen. Da die Zellverbinder nun fest in das Schaumelement verankert sind und weiterhin die einzelnen Solarzellen über die Zellverbinder fest miteinander verbunden sind, ergibt sich eine stabile Struktur. Diese wird zusätzlich durch eine vorzugsweise vorgesehene Folie weiter stabilisiert. So erhöht ein Zellverbinder, der auf einer Seite in das Schaumelement fest eingeschäumt ist und auf der anderen Seite in Kontakt mit einer auflaminierten Folie liegt, bereits die Stabilität und die Befestigung der Folie mit einer äußeren Struktur erheblich. Daher könnte bei einer solchen erfindungsgemäßen Anordnung auch auf eine feste Verankerung einer Folie mit einer äußeren Struktur oder einem Schaumelement verzichtet werden. Somit ergibt sich ein einfacheres und kostengünstigeres Herstellungsverfahren, welches gleichzeitig eine deutliche höhere Stabilität erreicht.

In einer besonders vorteilhaften Ausgestaltung der Erfindung wird eine höhere Stabilität dadurch erreicht, dass wenigstens zwei Zellverbinder mit wenigstens einem Querverbinder verbunden sind und der wenigstens eine Querverbinder wenigstens teilweise, bevorzugt vollständig in das Schaumelement eingeschlossen ist. Zusätzlich bzw. alternativ kann noch wenigstens ein weiterer Querverbinder zur Verbesserung der elektrischen Verbindung zwischen den Solarzellen vorgesehen sein, welcher nicht in das Schaumelement eingeschlossen ist.

In einer weiteren vorteilhaften Ausgestaltung der Erfindung weist der wenigstens eine Zellverbinder Mittel zur Erhöhung der Stabilität der Befestigung bzw. zur Erhöhung der Äuszugskraft aus dem Schaumelement auf. Solche Mittel können beispielsweise eine Verformung des wenigstens einen Zellverbinders sein. So kann dieser wellenförmig oder mäanderförmig verformt sein. Alternativ bzw. zusätzlich kann der wenigstens eine Zellverbinder auch eine Struktur der Oberfläche aufweisen. So kann die Oberfläche beispielsweise besonders rau sein. Es können aber auch Öffnungen oder Bohrungen in dem wenigstens einem Zellverbinder vorhanden sein, welche ein Eindringen oder bevorzugt ein Durchdringen des Schaums ermöglichen. Grundsätzlich kann auch ein Querverbinder diese Mittel zur Verbesserung der Auszugskraft aufweisen.

Ein erfindungsgemäßes Verfahren betrifft die Herstellung eines Bauelements für die Fassade eines Bauwerks oder für den Deckel eines Fahrzeugs. Dieses Verfahren umfasst die Schritte Bereitstellen einer Glasscheibe 10 sowie die Anordnung wenigstens einer Solarzelle 20 an dieser Glasscheibe 10, und schließlich das Einschäumen eines Teils wenigstens eines Zellverbinders 30 in ein Schaumelement 11, welches auch bevorzugt in Verbindung mit der Glasscheibe 10 steht. In weiteren Ausgestaltungen des Verfahrens sind die Schritte zur Herstellung der entsprechenden Ausführungsformen wie oben beschrieben inbegriffen.

### Beschreibung der Zeichnungen

Die Erfindung wird nachstehend ohne Beschränkung des allgemeinen Erfindungsgedankens anhand von Ausführungsbeispielen unter Bezugnahme auf die Zeichnungen exemplarisch beschrieben.
Figur 1 zeigt ein erfindungsgemäßes Bauelement in einer Draufsicht.
Die Figuren 2 bis 7 zeigen verschiedene Ausgestaltungen der Erfindung im Schnitt.
Die Figur 8 zeigt ein besonderes Ausführungsbeispiel zum Einsatz in Kraftfahrzeugen.
Die Figuren 9 und 10 zeigen Ausführungsbeispiele als Fassadenelemente.
Die Figuren 11 bis 14 zeigen verschiedene Ausgestaltungen von Zellverbindern.

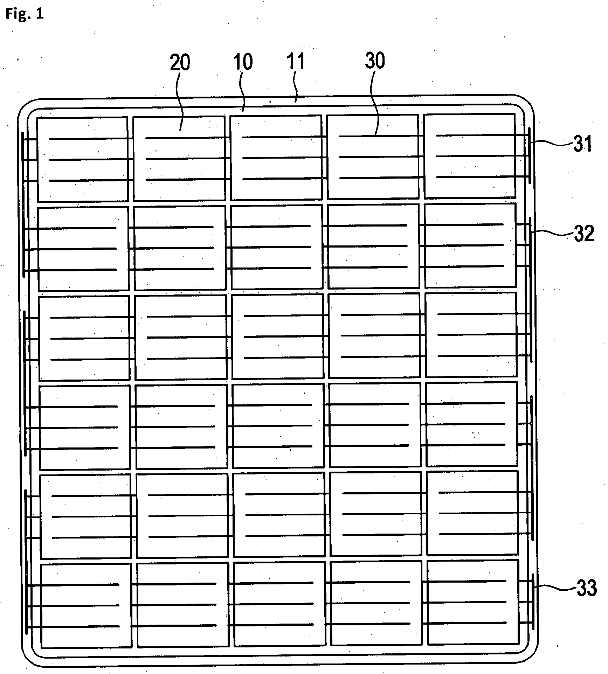

In Figur 1 ist ein erfindungsgemäßes Bauelement in der Draufsicht dargestellt. Das Bauelement umfasst eine Glasscheibe 10. Die Glasscheibe kann jede beliebige, der Aufgabe angepasste Form aufweisen. So kann sie beispielsweise abgerundete Ecken haben, wie in der Figur dargestellt. Ebenso kann sie in einer oder zwei Achsen gewölbt sein, oder eine andere freie, gekrümmte Form aufweisen, um sie beispielsweise an die Kontur eines Fahrzeugdachs anzupassen. Anstelle einer rechteckigen Form kann sie auch beliebige andere Formen haben. Bevorzugt hinter bzw. unter der Glasplatte und somit vor äußeren Umwelteinflüssen geschützt, ist wenigstens eine Solarzelle 20 angeordnet. In diesem Ausführungsbeispiel sind 30 Solarzellen in 6 Reihen mit jeweils 5 Solarzellen unter der Glasscheibe angeordnet. Grundsätzlich kann jede andere Anzahl von Solarzellen verwendet werden. Es müssen auch nicht quadratische Solarzellen, wie hier dargestellt verwendet werden. Die Solarzellen können grundsätzlich jede beliebige Form, auch rund, haben. Die elektrische Kontaktierung der Solarzellen 20 erfolgt durch Zellverbinder 30. Im hier dargestellten Beispiel sind die Solarzellen hintereinander geschaltet, so dass ein Zellverbinder von einer Solarzelle eine benachbarte Solarzelle kontaktiert. Die einzelnen Reihen von Solarzellen sind durch Querverbinder 31, 32 und 33 kontaktiert. Die Querverbinder 32 sind zur Verbindung von Reihen untereinander vorgesehen, während die Querverbinder 31 und 33 zur Kontaktierung der ersten bzw. letzten Solarzelle der Anordnung dienen. Es kann hier an die Querverbinder 31 und 33 ein Stromverbraucher bzw. eine Last angeschlossen werden, welche durch den Strom aus den Solarzellen gespeist wird. Weiterhin ist noch ein Schaumelement 11 am Rand der Glasscheibe 10 vorgesehen. Hier ist ein umlaufendes Schaumelement dargestellt. Es ist aber offensichtlich, dass dieses auch nur bestimmt Abschnitte umfassen kann. So könnte beispielsweise ein Schaumelement aus Segmenten mit Lücken zwischen den einzelnen Segmenten bestehen. Bevorzugt sind die äußeren Zellverbinder 30 der Solarzellen 20 an deren Enden von dem Schaumelement 11 umschlossen. Weiterhin sind bevorzugt die Querverbinder 31, 32 und 33 in den Schaum des Schaumelements eingeschlossen. Dadurch, dass die Zellverbinder benachbarte Solarzellen einer jeden Zeile miteinander verbinden, ergibt sich eine kettenartige Struktur von miteinander verbundenen Solarzellen, welche wiederum über die äußeren Zellverbinder in dem Schaumelement befestigt ist. Versuche haben ergeben, dass diese Struktur eine sehr hohe mechanische Stabilität aufweist und damit zur Gesamtstabilität des Bauelements wesentlich beiträgt. So kann hierdurch die notwendige Kraft zum Herausreißen des Bauelements aus einer äußeren Halterung wesentlich erhöht werden, was die Robustheit und Zuverlässigkeit bei Fassadenelementen und die Unfallsicherheit bei Deckeln für Kraftfahrzeuge deutlich erhöht.

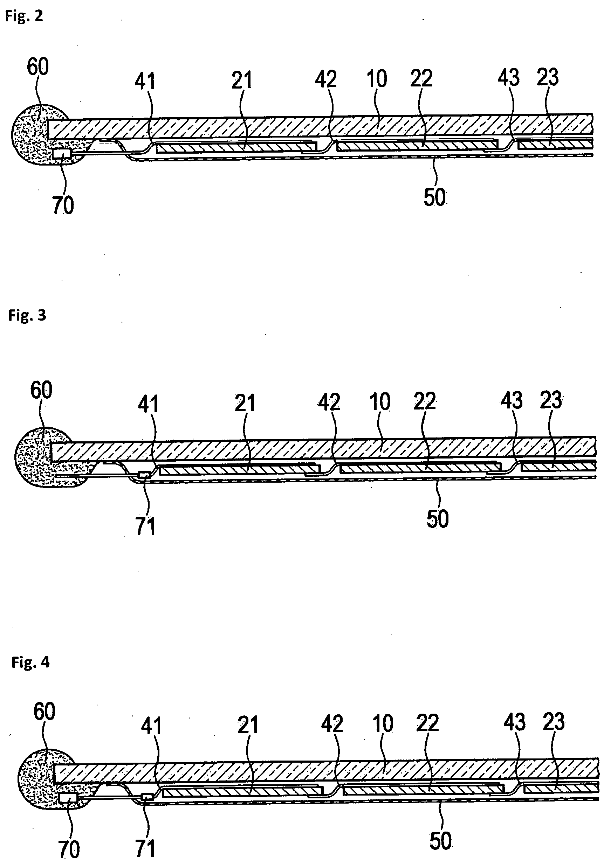

Figur 2 zeigt ein erfindungsgemäßes Bauelement im Schnitt. An der Außenkante der Glasscheibe 10 befindet sich ein Schaumelement 60. Dieses ist hier in einer bevorzugten Ausführungsform dargestellt und umschließt entsprechend die Außenseite der Glasscheibe. Alternativ kann es nur auf einer Seite oder auf zwei Seiten der Glasscheibe aufliegen. Somit kann die Glasscheibe beispielsweise durch ein U-förmiges Profil über das Schaumelement eingespannt werden. Unterhalb der Glasscheibe sind Solarzellen 21, 22, 23 angeordnet. Dabei ist die Solarzelle 22 mit der Solarzelle 23 über den Zellverbinder 43 und die Solarzelle 21 mit der Solarzelle 22 über den Zellverbinder 42 verbunden. Die Solarzelle 21 kann über den Zellverbinder 41 nach außen kontaktiert oder mit einer Solarzelle einer anderen Reihe durch einen Querverbinder 70 verbunden werden. Ein Querverbinder 70 kann auch zur externen Kontaktierung eingesetzt werden. Um eine hohe mechanische Festigkeit zu erreichen, ist der Querverbinder 70 in das Schaumelement 60 eingeschlossen. Somit können über den Querverbinder durch den Zellverbinder Zugkräfte von den Solarzellen aufgenommen werden, was zu einer wesentlichen Verbesserung der Stabilität dient. Weiterhin ist noch eine Folie 50 dargestellt, die die von der Glasscheibe abgewandte Seite der Solarzellen abdeckt. Somit sind die Solarzellen zwischen der Folie 50 und der Glasscheibe 10 eingeschlossen und bevorzugt dicht verkapselt. Durch die besondere Ausgestaltung der Zellverbinder ist es hier nicht mehr notwendig, eine besonders stabile und reißfeste Folie, auch als Splitterschutzfolie, einzusetzen. Stattdessen genügt eine einfachere und kostengünstigere Folie zur Abdichtung der Solarzellen. Durch den Einsatz einer hochreißfesten Splitterschutzfolie kann die Stabilität nochmals weiter deutlich erhöht werden.

In der Figur 3 ist eine weitere Variante dargestellt. Hier erfolgt die Verbindung verschiedener Reihen von Solarzellen über einen Querverbinder 71, welcher nicht in das Schaumelement integriert ist. Vielmehr ragt nur ein Ende des Zellverbinders 41 in das Schaumelement 60 hinein. Durch besondere Ausgestaltungen des Zellverbinders 41 kann jedoch auch die Festigkeit und die Auszugskraft aus dem Schaumelement 60 wesentlich erhöht werden.

In der Figur 4 ist eine weitere Ausführungsform dargestellt. Es sind zwei Querverbinder 70, 71 zu sehen. Während ein erster Querverbinder 70 für eine hohe Stabilität und Auszugskraft aus dem Schaumelement 60 sorgt, wird durch einen zweiten Querverbinder 71 die elektrische Kontaktierung zwischen den Solarzellen verbessert.

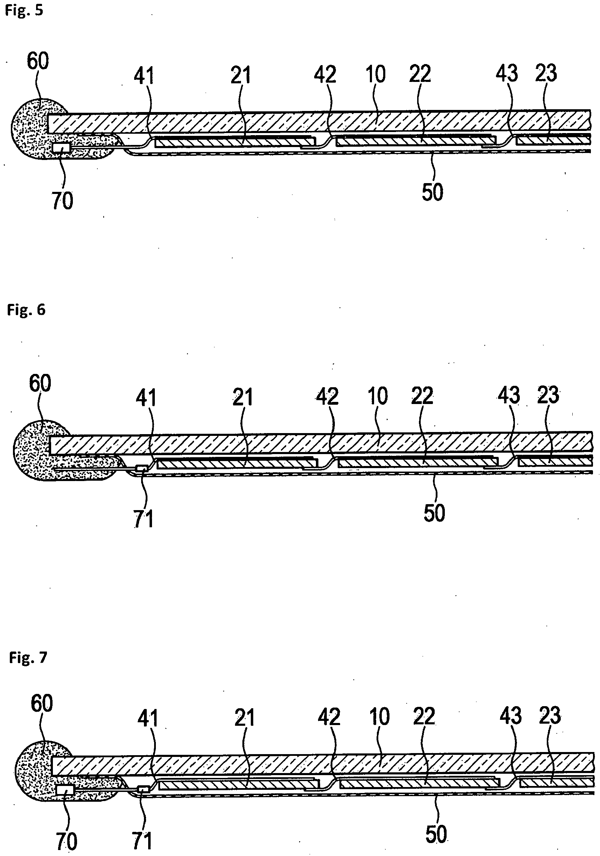

Die Figur 5 zeigt eine weitere Ausgestaltung, wobei das Schaumelement 60 nun auch das Ende der Folie 50 umschließt, um diese zusätzlich abzudichten und/oder zu stabilisieren bzw. zu verankern. Dies ergibt gegenüber den vorigen Ausführungsformen einen weiteren Gewinn an Stabilität. Im Übrigen entspricht diese Ausführungsform derjenigen aus der Figur 2.

Die Figur 6 zeigt eine weitere Ausgestaltung mit einer Folie, die vom Schaumelement stabilisiert wird, ähnlich der Ausführungsform aus Figur 3.

In der Figur 7 wird eine Ausführungsform ähnlich der Figur 4, jedoch mit einer durch das Schaumelement 60 stabilisierten Folie 50 gezeigt.

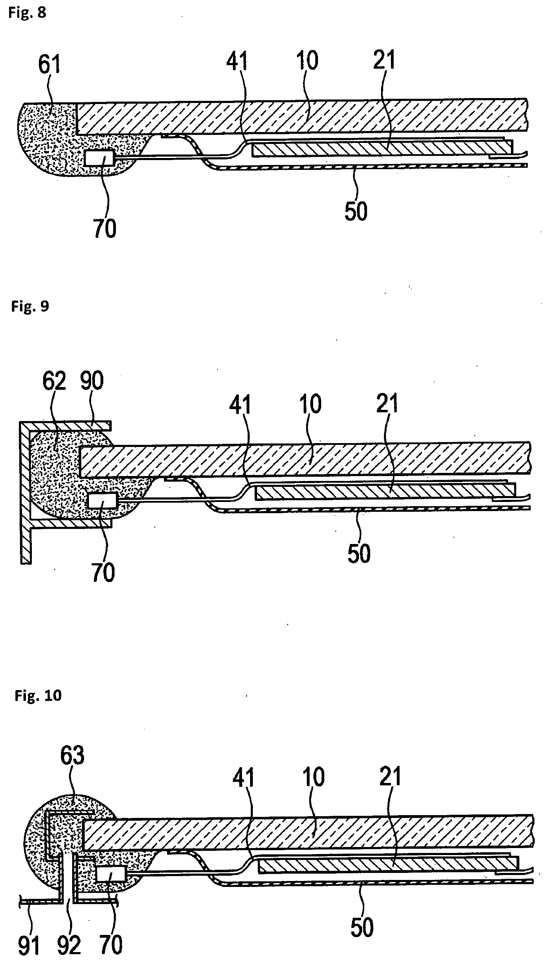

Die Figur 8 zeigt eine Ausführungsform, die besonders vorteilhaft als Glasdeckel in Kraftfahrzeugen einsetzbar ist. Hier ist die Oberseite des Schaumelements 61 vorzugsweise Plan mit der Oberfläche der Glasscheibe 10.

In der Figur 9 ist eine Ausführungsform, welche besonders bevorzugt als Fassadenelement einsetzbar ist, dargestellt. Hierbei liegt das Schaumelement 62 beispielhaft in einem C- oder U- förmigen Profil 90. Es kann aber auch nur einen Winkel, beispielsweise in L- Form sein. Durch ein H- förmiges Profil können benachbarte Bauelemente zusammen gehalten werden.

In der Figur 10 ist eine weitere Ausführungsform, die ebenfalls bevorzugt als Fassadenelement einsetzbar ist, dargestellt. Hierbei liegt das Schaumelement 63 in einem Profil 91, welches einen bevorzugt C- oder U- förmigen Teil aufweist. Dieses Profil kann Bestandteil einer Pfosten-Riegel-Konstruktion sein. Zudem ist es bevorzugt, wenn eine Bohrung 92 und/oder ein Gewinde zur Aufnahme einer Schraube vorgesehen ist.

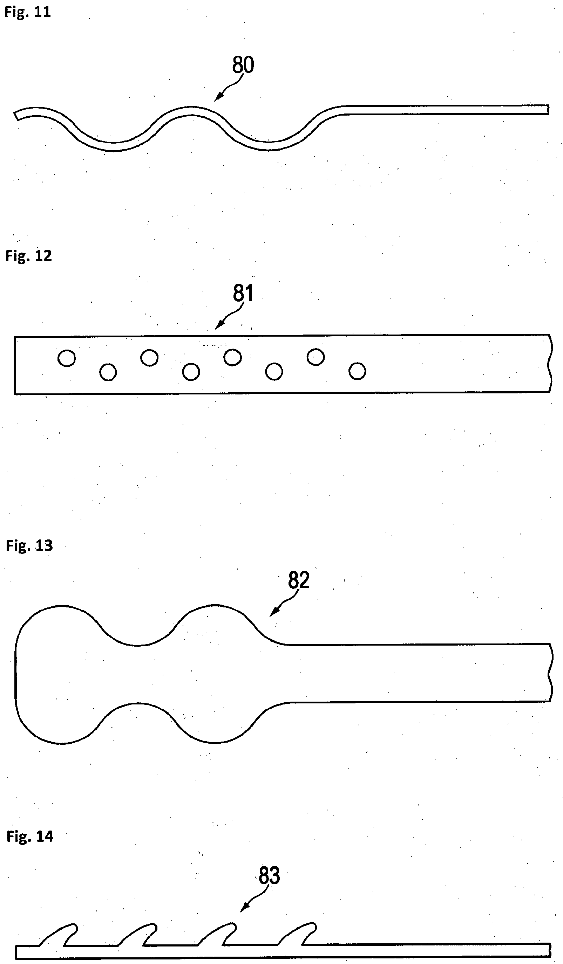

Die Figur 11 zeigt in der Seitenansicht einen Zellverbinder, der an seinem Ende wellenartig geformt ist, um die Auszugskraft und damit die Stabilität zu erhöhen.

Die Figur 12 zeigt in der Draufsicht einen Zellverbinder mit einem strukturierten Bereich, der beispielsweise Bohrungen oder zumindest Vertiefungen aufweist, die einen Formschluss mit dem Schaumelement ermöglichen. Besonders bevorzugt ist es, wenn das Schaumelement den Zellverbinder stellenweise durchdringen kann.

Die Figur 13 zeigt eine weitere Ausgestaltung eines Zellverbinders mit einer verbreiterten Kontur 82, um einen Formschluss mit dem Schaumelement zu erreichen.

Figur 14 zeigt in der Seitenansicht einen Zellverbinder mit Zähnen 83, die ebenfalls einen verbesserten Formschluss mit dem Schaumelement ermöglichen. Grundsätzlich können die hier gezeigten Ausgestaltungen der Zellverbinder auch miteinander kombiniert werden, um den Formschluss und die Haftung des Zellverbinders im Schaumelement weiter zu verbessern. Ebenso können auch die Querverbinder wie dargestellt ausgestaltet werden.

### Bezugszeichenliste

- 10: Glasscheibe
- 11: Schaumelement
- 20, 21, 22, 23: Solarzelle
- 30: Zellverbinder
- 31, 32, 33: Querverbinder
- 41, 42, 43: Zellverbinder
- 50: Folie
- 60, 61, 62, 63: Schaumelement
- 70, 71: Querverbinder
- 80: verformter Bereich
- 81: strukturierter Bereich
- 82: verbreiterte Kontur
- 83: Zähne
- 90, 91: Profil
- 92: Bohrung

## Patentansprüche

1. Bauelement für die Fassade eines Bauwerks oder für den Deckel eines Fahrzeugs, umfassend eine Glasscheibe (10) mit wenigstens einem Schaumelement (11), sowie wenigstens einer Solarzelle (20) an einer Seite der Glasscheibe (10),
**dadurch gekennzeichnet, dass**
wenigstens ein Zellverbinder (30), welcher sich seitlich neben der Solarzelle erstreckt, und welcher zur elektrischen Kontaktierung mit der wenigstens einen Solarzelle (20) verbunden ist, ausschließlich an dem seitlich von der Solarzelle entfernten Ende in das wenigstens eine Schaumelement (11) eingreift.

2. Bauelement nach Anspruch 1,
**dadurch gekennzeichnet, dass**
der wenigstens eine Zellverbinder an wenigstens einem Ende von dem Schaumelement umschlossen ist.

3. Bauelement nach einem der vorhergehenden Ansprüche,
**dadurch gekennzeichnet, dass**
ein Querverbinder vorgesehen ist, welcher mit mindestens einem Zellverbinder mechanisch verbunden ist.

4. Bauelement nach Anspruch 3,
**dadurch gekennzeichnet, dass**
der wenigstens eine Querverbinder mit dem wenigstens einen Zellverbinder elektrisch verbunden ist.

5. Bauelement nach Anspruch 4,
**dadurch gekennzeichnet, dass**
der wenigstens eine Querverbinder mit mehreren Zellverbindern verbunden ist.

6. Bauelement nach einem der Ansprüche 3 bis 5,
**dadurch gekennzeichnet,**
**dass** der wenigstens eine Querverbinder in das Schaumelement (11) eingreift.

7. Bauelement nach Anspruch 6,
**dadurch gekennzeichnet, dass**
der wenigstens eine Querverbinder von dem Schaumelement (11) umschlossen ist.

8. Bauelement nach einem der vorhergehenden Ansprüche,
**dadurch gekennzeichnet, dass**
der wenigstens eine Zellverbinder und/oder der wenigstens eine Querverbinder einen verformten Bereich (80) zum Formschluss mit dem wenigstens einen Schaumelement (11) aufweist, welcher in das Schaumelement (11) eingreift.

9. Bauelement nach einem der vorhergehenden Ansprüche,
**dadurch gekennzeichnet, dass**
der wenigstens eine Zellverbinder und/oder der wenigstens eine Querverbinder einen strukturierten Bereich mit Vertiefungen und/oder Bohrungen zur Verbesserung des Formschlusses mit dem Schaumelement (11) aufweist.

10. Verfahren zur Herstellung eines Bauelements nach Anspruch 1 für die Fassade eines Bauwerks oder für den Deckel eines Fahrzeugs, umfassend die Schritte
a. Bereitstellen einer Glasscheibe (10),
b. Anordnen von wenigstens einer Solarzelle (20) an der Glasscheibe (10), sowie
c. Einschäumen von wenigstens einem Zellverbinder (30) der wenigstens einen Solarzelle (20) in ein Schaumelement (11).

## Claims

1. A building component for the facade of a building or for the cover of a vehicle, comprising a glass pane (10) with at least one foam element (11), and at least one solar cell (20) on one side of the glass pane (10),
**characterized in that**
at least one cell connector (30), which extends laterally next to the solar cell, and which is connected for electrical contact with the at least one solar cell (20), interfaces with the at least one foam element (11) only at the end which is laterally remote from the solar cell.

2. Building component according to claim 1,
**characterized in that**
the at least one cell connector is enclosed by the foam element at at least one end.

3. Building component according to any of the preceding claims,
**characterized in that**
a transverse connector is provided, which is mechanically connected to at least one cell connector.

4. Building component according to claim 3,
**characterized in that**
the at least one transverse connector is electrically connected to the at least one cell connector.

5. Building component according to claim 4,
**characterized in that**
the at least one transverse connector is connected to multiple cell connectors.

6. Building component according to one of claims 3 to 5,
**characterized in that**
the at least one transverse connector interfaces with the foam element (11).

7. Building component according to claim 6,
**characterized in that**
the at least one transverse connector is enclosed by the foam element (11).

8. Building component according to any of the preceding claims,
**characterized in that**
the at least one cell connector and/or the at least one transverse connector comprise a deformed area (80) for tight-fitting with the at least one foam element (11), which interfaces with the foam element (11).

9. Building component according to any of the preceding claims,
**characterized in that**
the at least one cell connector and/or the at least one transverse connector comprises a structured area provided with recesses and/or holes for improving the tight-fitting with the foam element (11).

10. Method for manufacturing a building component according to claim 1 for the facade of a building or the cover of a vehicle, comprising the steps of
a. providing a glass pane (10);
b. arranging at least one solar cell (20) at the glass pane (10); and
c. foaming of at least one cell connector (30) of the at least one solar cell (20) into a foam element (11).

## Revendications

1. Élément de construction pour la façade d'un ouvrage de maçonnerie ou pour la couverture d'un véhicule, comprenant une vitre (10) avec au moins un élément en mousse (11) et avec au moins une cellule solaire (20) sur une face de la vitre (10), **caractérisé en ce qu'**au moins un connecteur de cellule (30), qui s'étend latéralement à côté de la cellule solaire et qui est connecté en vue de la mise en contact électrique avec l'au moins une cellule solaire (20), se met en prise exclusivement à une extrémité éloignée latéralement de la cellule solaire dans l'au moins un élément en mousse (11).

2. Élément de construction selon la revendication 1, **caractérisé en ce que** l'au moins un connecteur de cellule est entouré par l'élément en mousse à au moins une extrémité.

3. Élément de construction selon l'une des revendications précédentes, **caractérisé en ce qu'**il est prévu une traverse de liaison qui est reliée mécaniquement à au moins un connecteur de cellule.

4. Élément de construction selon la revendication 3, **caractérisé en ce que** l'au moins une traverse de liaison est reliée électriquement à l'au moins un connecteur de cellule.

5. Élément de construction selon la revendication 4, **caractérisé en ce que** l'au moins une traverse de liaison est reliée à plusieurs connecteurs de cellule.

6. Élément de construction selon l'une des revendications 3 à 5, **caractérisé en ce que** l'au moins une traverse de liaison se met en prise dans l'élément en mousse (11).

7. Élément de construction selon la revendication 6, **caractérisé en ce que** l'au moins une traverse de liaison est entourée par l'élément en mousse (11).

8. Élément de construction selon l'une des revendications précédentes, **caractérisé en ce que** l'au moins un connecteur de cellule et/ou l'au moins une traverse de liaison présentent une zone déformée (80) servant à l'engagement positif d'au moins un élément en mousse (11), qui se met en prise dans l'élément en mousse (11).

9. Élément de construction selon l'une des revendications précédentes, **caractérisé en ce que** l'au moins un connecteur de cellule et/ou l'au moins une traverse de liaison présentent une zone structurée avec des creux et/ou des perçages servant à améliorer l'engagement positif avec l'élément en mousse (11).

10. Procédé pour la fabrication d'un élément de construction selon la revendication 1 pour la façade d'un ouvrage de maçonnerie ou pour la couverture d'un véhicule, comprenant les étapes suivantes :
a. préparation d'une vitre (10),
b. disposition d'au moins une cellule solaire (20) sur la vitre (10), et
c. enrobage avec de la mousse d'au moins un connecteur de cellule (30) de l'au moins une cellule solaire (20) dans un élément en mousse (11).
